# EUROPÄISCHE PATENTANMELDUNG

(11) **EP 0 937 785 A2**
(43) Veröffentlichungstag der Anmeldung: **25.08.1999**
(21) Anmeldenummer: 98122224.3
(22) Anmeldetag: 23.11.1998
(51) Int. Cl.: C23C 14/56

(54) **Verfahren und Vorrichtung zum Beschichten der Aussenflächen einer Flasche**

(30) Priorität: 19.02.1998 DE 19807033
(71) Anmelder: Leybold Systems GmbH, D-63450 Hanau am Main (DE)
(72) Erfinder: Grimm, Helmut Dr., 64291 Darmstadt (DE); Henrich, Jürgen, 63694 Limeshain (DE); Rödling, Gert, 63179 Obertshausen (DE); Ulrich, Jürgen, 61137 Schöneck (DE)

(57) **Zusammenfassung**

Bei einem Verfahren zum Beschichten der Außenfläche einer Flasche (8) in einer Vakuumkammer mit mindestens einer Schleuse zum Einbringen und Ausbringen des Gefäßes und einer Prozeßstation mit Beschichtungsquelle wird
- in einem ersten Verfahrensschritt die Öffnung (30) der Flasche (8) von einem einen Strömungsweg (19,20,21) aufweisenden Stopfen (12) mit Absperrorgan (24) verschlossen,
- in einem zweiten Verfahrensschritt die Flasche (8) bei geöffnetem Strömungsweg (19,20,21) in die Vakuumkammer eingeschleust und während des Transports durch die Einschleusstrecke und vor Erreichen der Prozeßstation der Strömungsweg (19,20,21) vom Absperrorgan (24) verschlossen und
- in einem dritten Verfahrensschritt nach erfolgter Beschichtung die Flasche (8) aus der Vakuumkammer ausgeschleust, wobei der Strömungsweg (19,20,21) vom Absperrorgan (24) auf dem Wege durch die Ausschleusstrecke geöffnet und anschließend der Stopfen (12) aus der Öffnung (30) entfernt wird.

## Beschreibung

Die Erfindung betrifft ein Verfahren zum Beschichten der Außenflächen eines Gefäßes aus Kunststoff mit einer engen Öffnung und einem Halsansatz, insbesondere einer Flasche zum Aufbewahren einer Flüssigkeit, in einer Vakuumkammer mit mindestens einer Schleuse zum Einbringen und Ausbringen des Gefäßes und mit einer Prozeßstation mit Beschichtungsquelle sowie die Vorrichtung zur Durchführung des Verfahrens.

Bekannt ist eine Vorrichtung zum Beschichten von Polyesterflaschen mit SiO (US 4,478,874) in einer Vakuumkammer mit Hilfe einer ionengestützten Aufdampfquelle, bei der die Flaschen auf einem durch die Vakuumkammer bewegbaren Substrathalter angeordnet sind, wobei jeweils ein Haltedorn in das Innere der Flasche eingeführt ist, der elektrisch geerdet ist.

Bekannt ist auch eine Vorrichtung zum Ein- und Ausschleusen von Flaschen in eine Behandlungskammer, bei der eine in einem hohlzylindrischen Gehäuse rotierende Walze, die mit einer Vielzahl von an ihrer Umfangsfläche angeordneten Substrataufnehmern versehen ist, die Flaschen kontinuierlich von einer Beladestelle zu einer Eingabestation und später von einer Ausgabestation zurück zu einer Entladestation transportiert (DE 1932733).

Der vorliegenden Erfindung liegt die Aufgabe zugrunde, ein Verfahren und eine Vorrichtung zu schaffen, die geeignet sind, bei der Beschichtung der Außenflächen von dünnwandigen Flaschen aus Kunststoff sicher zu stellen, daß die Flaschen sich nicht verformen und aus ihrem Inneren keine den Beschichtungsprozeß störenden Gase oder Partikel nach außen durch den Flaschenhals abgeben und auch verhindern, daß solche Partikel aus der Vakuumkammer selbst in das Innere der Flaschen eindringen und damit das Flascheninnere kontaminieren.

Die Aufgabe wird gemaß der Erfindung dadurch gelöst, daß
- in einem ersten Verfahrensschritt die Öffnung des Gefäßes von einem einen Strömungsweg mit in diesen eingeschaltetem Absperrorgan aufweisenden Stopfen verschlossen wird,
- in einem zweiten Verfahrensschritt das Gefäß bei durchgängigem Strömungsweg in die Vakuumkammer eingeschleust und während des Transports durch die Einschleusstrecke und vor Erreichen der Prozeßstation der Strömungsweg vom Absperrorgan verschlossen wird und
- in einem dritten Verfahrensschritt nach erfolgter Beschichtung des Gefäß aus der Vakuumkammer ausgeschleust und der Strömungsweg vom Absperrorgan auf dem Wege durch die Ausschleusstrecke geöffnet wird.

Vorzugsweise findet eine Vorrichtung Verwendung mit mindestens einem Tragglied für den Transport des Gefäßes von der Beladestelle durch die Schleuse und die Vakuumkammer und zurück durch die Schleuse zu einer Entladestelle und mit einem durch einen in die Öffnung des Gefäßes einführbaren und diesen verschließenden Stopfen mit einem durch den Stopfen hindurchgeführten, das Gefäßinnere mit dem das Gefäß umgebenden Raum verbindenden Strömungsweg und einem den Durchgang durch den Strömungsweg kontrollierenden Absperrorgan.

Weitere Einzelheiten und Merkmale sind in den Patentansprüchen näher beschrieben und gekennzeichnet.

Die Erfindung läßt die verschiedensten Ausführungsmöglichkeiten zu; eine davon ist in den anhängenden Zeichnungen rein schematisch dargestellt, und zwar zeigen:

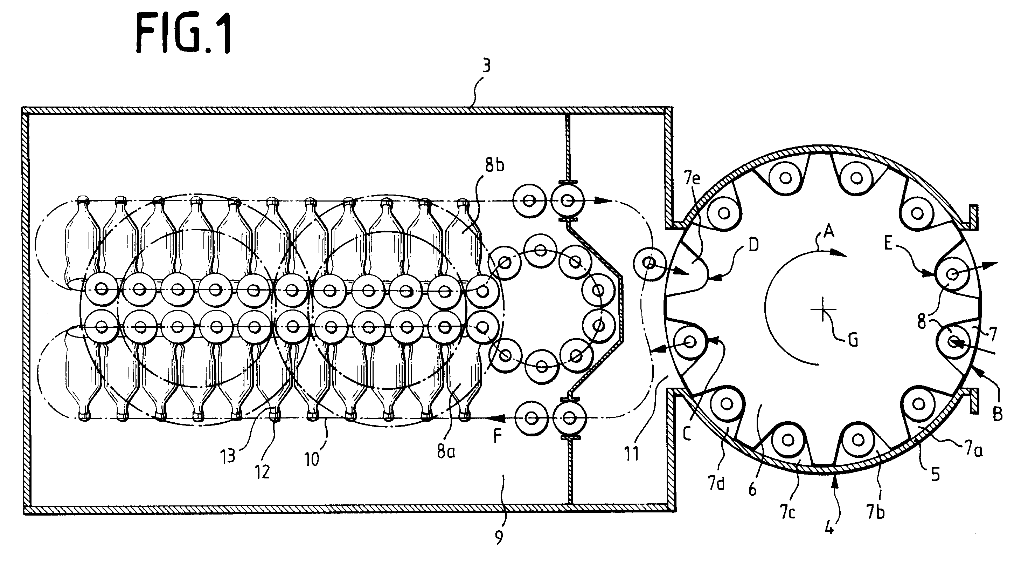

- Fig. 1: das Schema einer Vorrichtung zum Beschichten der Außenflächen von Flaschen aus Kunststoff in einer Vakuumkammer, die mit einer Walzenschleuse korrespondiert, über die die Flaschen kontinuierlich in den Prozeßraum eingeschleust und nach ihrer Behandlung aus diesem wieder ausgeschleust werden,
- Fig. 2: den Längsschnitt durch einen Stopfen zum Verschließen des Flaschenhalses einer Flasche mit einem in den Stopfen eingebauten Absperrorgan zum Kontrollieren des Durchgangs eines den Innenraum der Flasche mit dem Umgebungsraum verbindenden Strömungsweges, dargestellt in der Offen-Stellung,
- Fig. 3: die Draufsicht auf die das Absperrorgan führende Buchse gemäß Fig. 2 und
- Fig. 4: eine Ausführungsform des Stopfens, bei de das Absperrorgan mit einem Magneten zusammenwirkt.

Die Vorrichtung besteht im wesentlichen aus einer Vakuumkammer 3 mit einer in der Zeichnung nicht näher dargestellten Beschichtungsquelle, beispielsweise einer Sputterkathode, einer Schleuse 4 mit einer im kreiszylindrischen Schleusengehäuse 5 drehbar gelagerten Schleusenwalze 6 mit einer Vielzahl von in ihre zylindrische Umfangsfläche eingearbeiteten Flaschenaufnahmen 7,7',..., einem in der Vakuumkammer 3 angeordneten Förderer 10 mit einer Vielzahl von Traggliedern für den Transport der Flaschen 8,8',... durch den Prozeßraum 9 und von und zum Schleusendurchgang 11, durch den die Flaschen 8,8a,... von der Schleuse 4 in den Prozeßraum 9 und zurück gefördert werden.

Die unbeschichtete Flasche 8 wird in der Beladestelle B in eine Flaschenaufnahme 7 eingesetzt, während sich die Schleusenwalze 6 in Pfeilrichtung A dreht. Die Schleusenwalze 6 transportiert nun die Flasche 8, bis diese die Eingabestation C erreicht hat. Während des Weges von der Beladestelle B zur Eingabestation C steht die Flaschenaufnahme 7 in Verbindung mit einer Vakuumpumpe, so daß der Druck in der Flaschenaufnahme 7 auf dem Weg zur Eingabestation C dem Druck im Prozeßraum 9 angeglichen werden kann.

Von der Eingabestation c erfolgt der Weitertransport der Flasche 8 mittels des Kettenförderers 10, und zwar in Pfeilrichtung F entlang des strichpunktiert eingezeichneten Pfades, wobei die Flasche 8 eine zur Rotationsachse G der Schleusenwalze 6 geneigte Position einnimmt, wie dies am Beispiel der Flasche 8a gezeigt ist. Nachdem die Flasche einmal den Prozeßraum 9 in Pfeilrichtung F durchlaufen hat, wird sie in entgegengesetzter Richtung transportiert und dabei in eine zur Rotationsachse G parallelen Position geschwenkt und schließlich nach mehrmaligem Transport durch den Prozeßraum 9 wieder in einer zur Rotationsachse G geneigten Lage, wie dies am Beispiel der Flasche 8b gezeigt ist, zur Ausgabestation D gefördert, von wo aus die Flasche dann in lotrechter Position von der Flaschenaufnahme 7e übernommen wird und dann von der Schleusenwalze 6 zur Entladestelle E transportiert wird. Auf dem Weg von der Ausgabestation D zur Entladestelle E wird der Druck in der Flaschenaufnahme 7e dem Druck der Umgebung angeglichen.

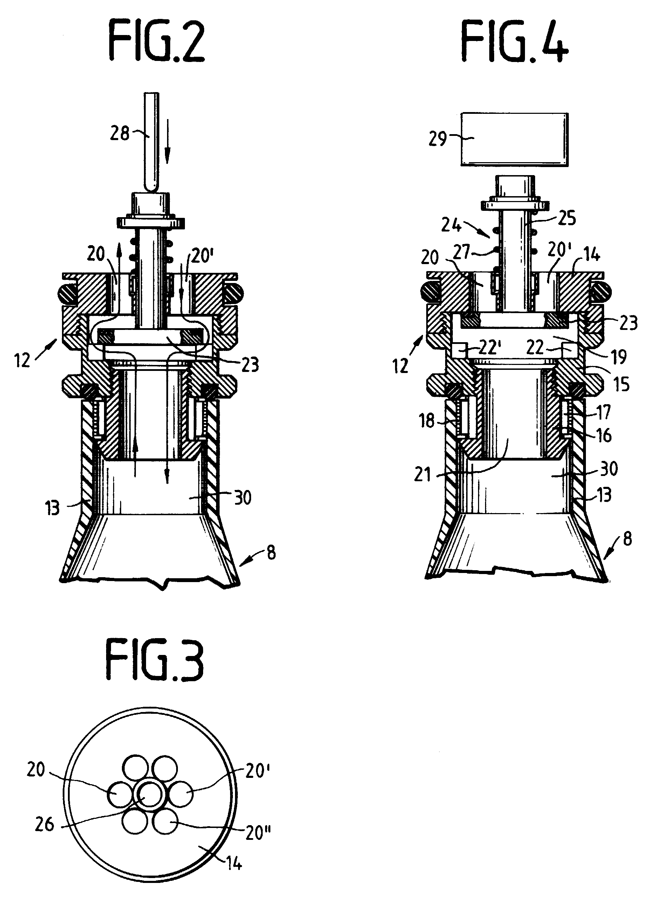

Damit die Flasche 8,8a,... während des Beschichtungsprozesses, d. h. während ihres Aufenthaltes im Prozeßraum 9 keine den Beschichtungsprozeß störenden Gase oder Partikel in den Prozeßraum abgibt, wird die Flasche 8,8a,... vor dem Einsetzen in die Flaschenaufnahme 7,7a,... im Bereich der Beladestelle B mit einem Stopfen 12 verschlossen (wie er in den Fig. 2-4 dargestellt ist), wobei der Stopfen 12 vom Flaschenhals 13 wieder abgezogen wird, nachdem die Flasche 8,8a,... die Entladestelle E erreicht hat.

er Stopfen 12 besteht aus einer Buchse 14, die mit dem Gehäuseteil 15 verschraubt ist, wobei das Gehäuseteil 15 nach unten zu mit einem Führungsstutzen 16 verschraubt ist, der an einer radial äußeren Fläche mit einer Ringnut 17 versehen ist, in die ein Federring 18 eingesetzt ist, der dem Führungsstutzen 16 einen festen sitz im Flaschenhals 13 ermöglicht. Die Längsbohrung 19 im Gehäuseteil 15 korrespondiert mit den Ventilbohrungen 20,20',... der Buchse 14 und der Längsbohrung 21 des Führungsstutzens und ist im übrigen mit sich in der Längsbohrung 19 radial erstreckenden Nasen 22,22',... versehen, auf die sich der Teller 23 des Ventilkörpers 24 in der Ventil-Offen-Position (Fig. 2) aufsetzte kann.

Der ein Absperrorgan bildende Ventilkörper 24 ist mit seinem Schaft 25 in einer zentralen Bohrung 26 der Buchse 14 gehalten und verschiebbar geführt, wobei der Ventilschaft 25 von einer Druckfeder 27 umschlossen ist, die sich einerseits am Kopfteil 28 des Ventilkörpers 24 abstützt und andererseits auf der Buchse 14 aufsitzt. Die Zentralbohrung 26 ist von sechs Ventilbohrungen 20,20',... umschlossen, die den Durchfluß der Luft aus dem Flascheninneren nach außen und umgekehrt ermöglichen.

Wie Fig. 2 zeigt, wird der Ventilkörper 24 mit einem Stößel 28 aufgehalten, und zwar gegen die Kraft der Druckfeder 27, so daß der Teller 23 auf den Nasen 22,22',... aufliegt und der Strömungsweg durch den Stopfen in beiden Richtungen geöffnet ist. Während des Transports der Flaschen 8,8',... durch den Prozeßraum 9 liegt der Teller 23 fest an seinem Sitz an der Buchse 14 an und sperrt die Ventilbohrungen 20,20',... ab. Der Ventilkörper 24 kann auch, wie das Fig. 4 zeigt, von einem Magneten 29 gegen die Kraft der Druckfeder 27 in seine Offen-Stellung bewegt werden.

Die Mittel zum Öffnen des Strömungsweges, d. h. zum Niederdrücken des Ventilkörpers 24 gegen die Kraft der Feder 27, nämlich der Stößel 28 oder der Magnet 29, sind zweckmäßigerweise auf der in der Zeichnung nicht näher dargestellten Walzenschleuse 4 jeweils im Bereich oberhalb des jeweiligen Flaschenkopfes angeordnet und drücken den jeweiligen Ventilkörper 24 auf dem Weg von B nach C und auf dem Weg von D nach E nieder, d. h. in die Offen-Stellung (Fig. 2).

### Bezugszeichenliste

- 3: Vakuumkammer
- 4: Schleuse
- 5: Schleusengehäuse
- 6: Schleusenwalze
- 7,7',...: Flaschenaufnahme
- 8,8a,8b,...: Flasche, Gefäß
- 9: Prozeßraum
- 10: Förderer, Kettenförderer
- 11: Schleusendurchgang
- 12: Stopfen
- 13: Flaschenhals
- 14: Buchse
- 15: Gehäuseteil
- 16: Führungsstutzen
- 17: Ringnut
- 18: Federring
- 19: Längsbohrung
- 20,20',...: Längsbohrung, Ventilbohrung
- 21: Längsbohrung
- 22,22',...: Nase
- 23: Teller
- 24: Ventilkörper, Absperrorgan
- 25: Ventilschaft
- 26: Zentralbohrung
- 27: Druckfeder
- 28: Stößel
- 29: Magnet
- 30: Öffnung
- A: Drehrichtung der Walze
- B: Beladestelle
- C: Eingabestation
- D: Ausgabestation
- E: Entladestation
- F: Transportrichtung der Flaschen
- G: Rotationsachse der Walze

## Patentansprüche

1. Verfahren zum Beschichten der Außenfläche eines Gefäßes aus Kunststoff mit einer engen Öffnung und einem Halsansatz, insbesondere einer Flasche (8,8a,...) zum Aufbewahren einer Flüssigkeit, in einer Vakuumkammer (3) mit mindestens einer Schleuse (4) zum Einbringen und Ausbringen des Gefäßes und einer Prozeßstation mit Beschichtungsquelle, **dadurch gekennzeichnet,** daß
- in einem ersten Verfahrensschritt die Öffnung (30) des Gefäßes (8,8a,...) von einem einen Strömungsweg (19,20,21) aufweisenden Stopfen (12) mit Absperrorgan (24) verschlossen wird,
- in einem zweiten Verfahrensschritt das Gefäß (8,8a,...) bei geöffnetem Strömungsweg (19,20,21) in die Vakuumkammer (3) eingeschleust und während des Transports durch die Einschleusstrecke (B-C) und vor Erreichen der Prozeßstation der Strömungsweg (19,20,21) vom Absperrorgan (24) verschlossen wird und
- in einem dritten Verfahrensschritt nach erfolgter Beschichtung das Gefäß (8,8a,...) aus der Vakuumkammer (3) ausgeschleust und der Stromungsweg (19,20,21) vom Absperrorgan (24) auf dem Wege durch die Ausschleusstrecke (D-E) geöffnet und anschließend der Stopfen (12) aus der Öffnung (30) entfernt wird.

2. Vorrichtung zum Beschichten der Außenfläche eines Gefäßes aus Kunststoff mit einer engen Öffnung und eine Halsansatz, insbesondere einer Flasche (8,8a,...) zum Aufbewahren einer Flüssigkeit, in einer Vakuumkammer (3) mit mindestens einer Schleuse (4) zum Einbringen und/oder Ausbringen des Gefäßes und mit einer Prozeßstation mit Beschichtungsquelle und mit mindestens einem Tragglied für den Transport des Gefäßes von der Beladestelle (B) durch die Schleuse (4) und die Vakuumkammer (3) und zurück durch die Schleuse (4) zu einer Entladestelle (E), **gekennzeichnet durch** einen in die Öffnung (30) des Gefäßes (8,8a,...) einführbaren und diesen verschließenden Stopfen (12)mit einem durch den Stopfen (12) hindurchgeführten, das Gefäßinnere mit dem das Gefäß umgebenden Raum verbindenden Strömungsweg (19,20,21) und einem den Durchgang durch den Strömungsweg kontrollierenden Absperrorgan (23,25).

3. Vorrichtung nach Anspruch 2, **dadurch gekennzeichnet**, daß das den Strömungsweg (19,20,21) kontrollierende Absperrorgan (24) ein gesteuertes Rückschlagventil ist, dessen Ventilkörper (23) von einer Feder (27) belastet ist und mit einem Stößel zusammenwirkt, der in der Einschleusstrecke (B-C) auf den Ventilkörper (23,25) im Öffnungssinne einwirkt und im Gehäuse (5) oder in der Schleusenwalze (6) längsverschiebbar gelagert ist.

4. Vorrichtung nach Anspruch 2, **dadurch gekennzeichnet,** daß das den Strömungsweg (19,20,21) kontrollierende Absperrorgan (23,25) ein gesteuertes Rückschlagventil ist, dessen Sperrung oder Durchfluß durch einen mit dem Sperrorgan (23,25) zusammenwirkenden Magneten (29) aufhebbar ist, wozu der Magnet (29) im Bereich der Einschleusstrecke (B-C) und/oder der Ausschleusstrecke (D-E) am Gehäuse (5) der Schleuse (4) oder der Schleusenwalze (6) angeordnet ist und das Sperrorgan (23,25) im Öffnungssinne beaufschlagt.
